(19) **Europäisches Patentamt**

**European Patent Office**

**Office européen des brevets**

(11) **EP 0 899 897 B1**

(12) **EUROPÄISCHE PATENTSCHRIFT**

(45) Veröffentlichungstag und Bekanntmachung des Hinweises auf die Patenterteilung:
**17.12.2003 Patentblatt 2003/51**

(51) Int Cl.⁷: **H04B 7/24**, H04J 1/06, H04B 7/26

(21) Anmeldenummer: **98104567.7**

(22) Anmeldetag: **13.03.1998**

(54) **Verfahren zum Einstellen der Sendeträgerfrequenz in einer Teilnehmerstation eines Punkt-zu-Mehrpunkt Funkübertragungssystems**

Method for adjusting the carrier frequency of a user station in a point to multipoint transmission system

Procédé d'ajustement de la fréquence porteuse d'une station d'abonné dans un système de transmission point-multipoints

(84) Benannte Vertragsstaaten:
**DE ES FI FR GB IT SE**

(30) Priorität: **29.08.1997 DE 19737758**

(43) Veröffentlichungstag der Anmeldung:
**03.03.1999 Patentblatt 1999/09**

(73) Patentinhaber: **Marconi Communications GmbH 71522 Backnang (DE)**

(72) Erfinder:
• **Rümmer, Wolfgang 71522 Backnang (DE)**
• **Bollmann, Andreas 54439 Esingen (DE)**

(74) Vertreter: **Gleiss & Grosse Leitzstrasse 45 70469 Stuttgart (DE)**

(56) Entgegenhaltungen:
WO-A-97/19557　　　　US-A- 4 670 889
US-A- 5 249 305　　　　US-A- 5 450 617

• **PATENT ABSTRACTS OF JAPAN vol. 014, no. 073 (E-0887), 9. Februar 1990 (1990-02-09) & JP 01 290321 A (NEC CORP), 22. November 1989 (1989-11-22)**

**Beschreibung**

Stand der Technik

Die vorliegende Erfindung betrifft ein Verfahren zum Einstellen der Sendeträgerfrequenz in einer Teilnehmerstation eines Punkt-zu-Mehrpunkt Funkübertragungssystems, wobei eine Basisstation mit so vielen Modems ausgestattet ist, wie maximal Teilnehmerstationen mit ihr eine Funkverbindung aufnehmen können und ebenfalls jede Teilnehmerstation ein Modem besitzt.

Ein derartiges Punkt-zu-Mehrpunkt Funkübertragungssystem ist aus der nicht vorveröffentlichten deutschen Patentanmeldung 196 355 33.8 bekannt. Bei diesem Funkübertragungssystem erfolgt die Kommunikation zwischen der Basisstation und den einzelnen Teilnehmerstationen durch Vielfachzugriff im Frequenzmultiplex (FDMA). Dabei wird die Übertragungskapazität flexibel an den Bedarf und die Zahl der Teilnehmer angepaßt, indem die Bandbreite der einzelnen Übertragungskanäle auf die von den einzelnen Teilnehmern jeweils geforderte Datenübertragungsrate eingestellt wird. Es wird außerdem eine flexible Zuweisung und Anpassung von Übertragungskapazitäten auf die zugeschalteten Teilnehmerstationen unterbrechungs- und störungsfrei ermöglicht. Dazu weist jedes Modem in der Basisstation und in den einzelnen Teilnehmerstationen mindestens zwei Sende- und mindestens zwei Empfangskanäle auf, wobei die Signalübertragung zwischen der Basisstation und einer Teilnehmerstation zunächst nur über einen Sende- bzw. Empfangskanal erfolgt. Bei Änderung der Übertragungskanäle besorgt eine Steuereinrichtung in dem mindestens einen nicht in Betrieb befindlichen Sende- bzw. Empfangskanal die Einstellung der neuen Übertragungsparameter (Kanalträgerfrequenz, Datenrate, Modulation, Codierung, Sendepegel), während die Signalübertragung in den anderen Sende- bzw. Empfangskanälen fortgesetzt wird. Nach abgeschlossener Aquisition des Funkkanals mit den neuen Übertragungsparametern erfolgt eine Umschaltung auf den zuvor nicht in Betrieb befindlichen Sende- bzw. Empfangskanal.

Aufgabe der vorliegenden Erfindung ist es, ein Verfahren der eingangs genannten Art anzugeben, das mit einem möglichst geringen Hardwareaufwand die Sende- und Empfangsträgerfrequenzen der Basisstation und der Teilnehmerstationen aufeinander synchronisiert.

Vorteile der Erfindung

Gemäß den Merkmalen des Anspruchs 1 wird die genannte Aufgabe dadurch gelöst, daß alle Empfangs- und alle Senderträger-frequenzen der Modems der Basisstation von einer gemeinsamen Referenzfrequenz abgeleitet werden, daß jeweils ein von einer Teilnehmerstation ausgesendeter Sendeträger mit der korrespondierenden Empfangsträgerfrequenz in der Basisstation verglichen wird, anschließend eine ermittelte Frequenzablage zwischen dem Sendeträger der Teilnehmerstation und dem Empfangsträger der Basisstation der Teilnehmerstation mitgeteilt und schließlich die Sendeträgerfrequenz der Teilnehmerstation so eingestellt wird, daß die Frequenzablage minimal wird. Gemaß einem Unteranspruch wird auch die Empfangsträgerfrequenz der Teilnehmerstation in Abhängigkeit von der Frequenzablage so verändert, daß die Frequenzablage minimal wird.

Dadurch, daß in der Basisstation alle Sende- und Empfangsträgerfrequenzen von einer Referenz abgeleitet werden, ist die relative Lage aller Trägerfrequenzen zueinander sehr stabil. Die Lage der Trägerfrequenzen der einzelnen Teilnehmerstationen orientiert sich an der relativen Lage der Trägerfrequenzen der Basisstation. Man kann somit in der Basisstation und in den Teilnehmerstationen freilaufende Lokaloszillatoren verwenden, die nicht mit aufwendigen Schaltungsmitteln aufeinander synchronisiert werden müssen.

Nach einem weiteren Unteranspruch weist jedes Modem in der Basisstation und in den Teilnehmerstationen mindestens zwei Empfangs- und zwei Sendekanäle auf, wobei von einem Empfangs-/Sendekanal auf einen anderen Empfangs-/Sendekanal umgeschaltet wird, wenn mit einem anderen Paar von Sende- und Empfangsträgerfrequenzen Daten übertragen werden sollen. Vor dem Umschalten der Empfangs- und Sendekanäle wird das neue Paar von Sende- und Empfangsträgerfrequenzen für die betroffene Teilnehmerstation aus der Frequenzablage zwischen dem vorherigen Sendeträger der Teilnehmerstation und dem vorherigen Empfangsträger der Basisstation und aus dem neuen Sendeträger und dem neuen Empfangsträger der Basisstation abgeleitet.

Beschreibung eines Ausführungsbeispiels

Anhand eines in der Zeichnung dargestellten Ausführungsbeispiels wird nachfolgend die Erfindung näher erläutert.

Es zeigen:

Figur 1 ein Prinzipschaltbild einer Basisstation,
Figur 2 ein Prinzipschaltbild einer Teilnehmerstation und

Figur 3 ein Funktionsschema zur Trägerfrequenzableitung für eine Teilnehmerstation.

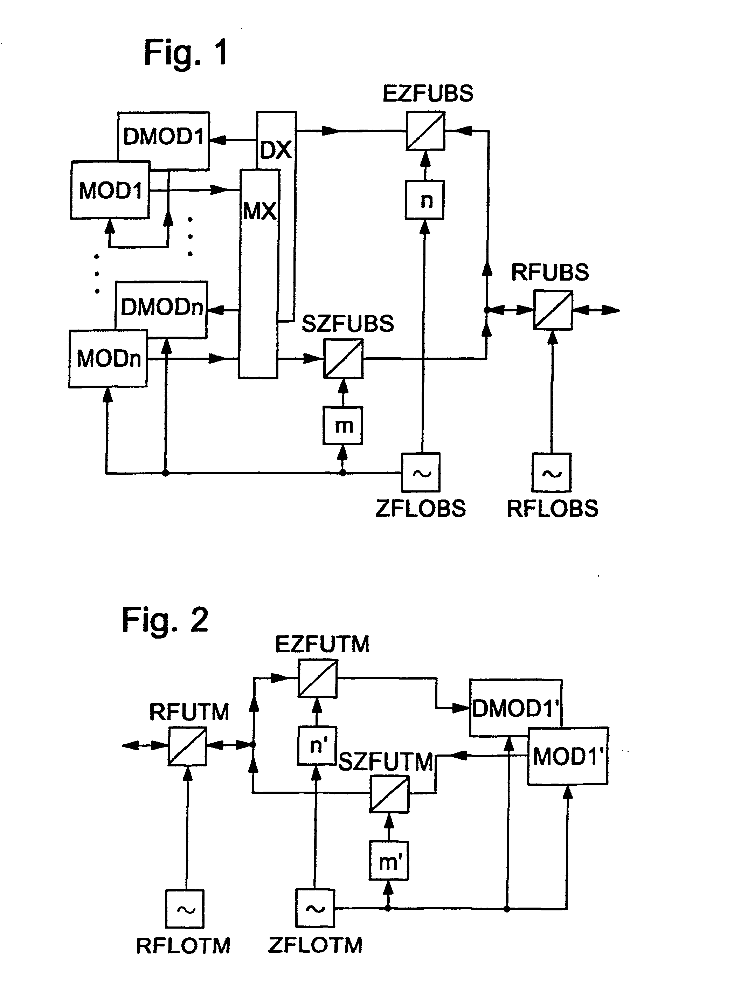

Ein Punkt-zu-Mehrpunkt Funkübertragungssystem besteht aus einer Basisstation, dessen prinzipielles Blockschaltbild in Figur 1 dargestellt ist, und mehreren Teilnehmerstationen, von denen jede im Prinzip gemäß dem in Figur 2 dargestellten Blockschaltbild aufgebaut ist.

Die in Figur 1 gezeigte Basisstation besitzt n Modems, wobei n der maximal möglichen Anzahl von Teilnehmerstationen entspricht, die mit der Basisstation in Funkverbindung treten können. Jedes Modem besteht aus einem Modulator MOD1 ... MODn und einem Demodulator DMOD1 ... DMODn. Ebenfalls besitzt jede Teilnehmerstation (vgl. Figur 2) ein Modem bestehend aus einem Demodulator DMOD1' und einem Modulator MOD1'.

In Outbound-Richtung das ist die Übertragungsrichtung von der Basisstation zur Teilnehmerstation - werden die vom Modulator MOD1 der Basisstation erzeugten Signale zur Teilnehmerstation übertragen und vom dortigen Demodulator DMOD1' empfangen. In entgegengesetzter Richtung - in Inbound-Richtung - werden die in der Teilnehmerstation vom Modulator MOD1' erzeugten Signale zur Basisstation übertragen und dort vom Demodulator DMOD1 empfangen. Um den Empfang der in beiden Richtungen übertragenen Signale zu ermöglichen, muß der Empfangsträger des Demodulators DMOD1' der Teilnehmerstationen auf den Sendeträger des Modulators MOD1 der Basisstation und ebenso der Sendeträger des Modulators MOD1' der Teilnehmerstation auf den Empfangsträger des Demodulators DMOD1 der Basisstation abgestimmt sein.

In der Basisstation werden die Sende- und Empfangsträgerfrequenzen in allen Modulatoren MOD1 ... MODn und Demodulatoren DMOD1 ... DMODn von einem freilaufenden Lokaloszillator ZFLOBS abgeleitet. Alle Modulatoren MOD1 ... MODn sind über einen Multiplexer MX an einen Sende-Zwischenfrequenzumsetzer SZFUBS und alle Demodulatoren DMOD1 ... DMODn an einen Empfangs-Zwischenfrequenzumsetzer EZFUBS angeschlossen. Die Zwischenfrequenzumsetzer SZFUBS und EZFUBS erhalten ihre Referenzfrequenzen ebenfalls aus dem Lokaloszillator ZFLOBS, wobei unterschiedliche Frequenzvervielfachungsfaktoren - m für den Sendeumsetzer SFUBS und n für den Empfangsumsetzer EZFUBS - vorgesehen sind. Darauf folgt ein Hochfrequenzumsetzer RFUBS, der seine Referenzfrequenz von einem eigenen Lokaloszillator RFLOBS erhält. Wie gesagt, sind beide Lokaloszillatoren ZFLOBS und RFLOBS freilaufend, und es werden keine Maßnahmen ergriffen, um die Oszillatorfrequenzen zu stabilisieren. Das für die Signalübertragung in Outbound-Richtung zur Verfügung stehende Frequenzband erfährt bei einer Frequenzdrift des Lokaloszillators ZFLOBS eine Dehnung oder Stauchung (multiplikativer Effekt) und einen Offset (additiver Effekt), wenn die Frequenzen der beiden Lokaloszillatoren ZFLOBS und RFLOBS driften. Dadurch, daß alle Modulatoren MOD1 ... MODn und alle Demodulatoren DMOD1 ... DMODn ihre Sende- und Empfangsträgerfrequenzen von einem gemeinsamen Lokaloszillator ZFLOBS ableiten, bleiben alle Sendeträger und alle Empfangsträger in einem festen Raster, das heißt, die Verhältnisse der Trägerabstände bleiben konstant.

Jede einzelne Teilnehmerstation weist zwei freilaufende Lokaloszillatoren RFLOTM und ZFLOTM auf. Der erste Lokaloszillator RFLOTM liefert eine Referenzfrequenz für einen Hochfrequenzumsetzer RFUTM und der zweite Lokaloszillator ZFLOTM liefert die Referenzfrequenzen für einen Sende-Zwischenfrequenzumsetzer SZFUTM und für einen Empfangs-Zwischenfrequenzumsetzer EZFUMT. Für den Sendeumsetzer SZFUMT und den Empfangsumsetzer EZFUMT sind verschiedene Vervielfachungsfaktoren m' und n' der Referenzfrequenz des Lokaloszillators ZFLOTM vorgesehen. Außerdem leiten der Modulator MOD1' und der Demodulator DMOD1' ihre Sende- und Empfangsträgerfrequenz von der Referenfrequenz des Lokaloszillators ZFLOTM ab. Da die freilaufenden Lokaloszillatoren RFLOTM und ZFLOTM aller Teilnehmerstationen nicht aufeinander synchronsiert sind, kommt es ebenfalls zu einer Dehnung oder Stauchung und zu einem Offset des Inbound-Frequenzbandes. Zudem driften die einzelnen Träger des Inbound-Frequenzbandes relativ zueinander, so daß die Träger untereinander nicht mehr äquidistant sind. Wegen der relativen gegenseitigen Drift der Träger im Inbound-Frequenzband besteht die Gefahr des Übersprechens zwischen den Frequenzkanälen der einzelnen Träger, so daß genügend große Abstände (guardbands) zwischen den einzelnen Frequenzkanälen vorgesehen werden müßten. Im Sinne einer optimalen Frequenzökonomie sollte aber mit möglichst schmalen guardbands ausgekommen werden. Das geht aber nur, wenn man es schafft, die Träger untereinander äquidistant zu halten. Dieses Ziel erreicht man durch folgende Maßnahmen:

Der von der Teilnehmerstation zur Basisstation übertragene Sendeträger wird im zugehörigen Demodulator DMOD1 oder einer getrennten Schaltungseinheit mit der Sollfrequenz des Empfangsträgers dieses Demodulators DMOD1 verglichen. Wird eine Frequenzablage zwischen dem Sendeträger der Teilnehmerstation und dem Empfangsträger der Basisstation ermittelt, so sendet die Basisstation den Frequenzablagewert zu der Teilnehmerstation zurück, und es wird die Sendeträgerfrequenz des Modulators MOD1' so eingestellt, daß die Frequenzablage minimal wird. Der von der Basisstation ermittelte Frequenzablagewert kann in einem Broadcastkanal oder in einem Overheadbereich des Nutzsignalkanals zur Teilnehmerstation übertragen werden. Die geschilderte Prozedur wird zwischen der Basisstation und jeder Teilnehmerstation durchgeführt. So erreicht man schließlich ein äquidistantes Raster von Sendeträgern im Inboundfrequenzband, das sich an dem Trägerfrequenzraster des Outbound-Frequenzbandes orientiert.

Nicht nur der Sendeträger der Teilnehmerstationen kann in Abhängigkeit von dem Frequenzablagewert nachgeführt werden, sondern auch der Empfangsträger des Demodulators DMOD1' in der Teilnehmerstation.

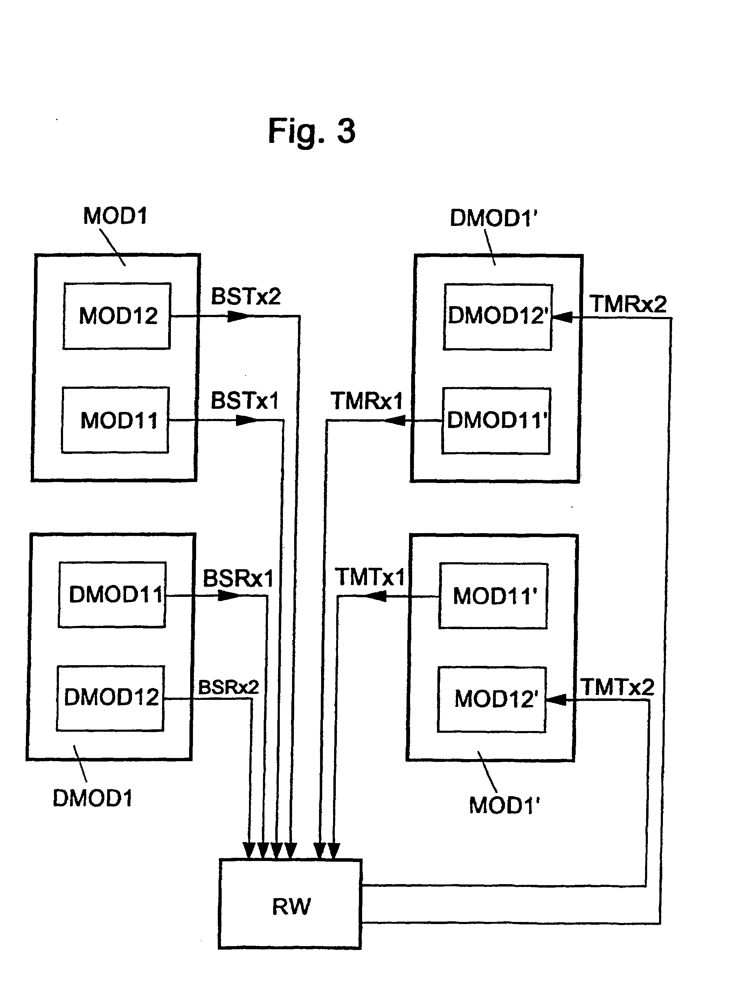

Einleitend wurde bereits geschildert, daß es sehr zweckmäßig ist, um sowohl in der Basisstation als auch in den einzelnen Teilnehmerstationen eine unterbrechungsfreie Umschaltung von einem Frequenzkanal auf einen anderen vornehmen zu können, jedes Modem in der Basisstation und in den Teilnehmerstationen mit mindestens zwei Empfangs- und zwei Sendekanälen auszustatten. In der Figur 3 ist schematisch angedeutet, daß in der Basisstation der Modulator MOD1 zwei Sendekanäle MOD11, MOD12 und der Demodulator DMOD1 zwei Empfangskanäle DMOD11, DMOD12 aufweist. Ebenso besteht in der Teilnehmerstation der Modulator MOD1' aus zwei Modulatoren MOD11', MOD12' und der Demodulator DMOD1' aus zwei Demodulatoren DMOD11', DMOD12'. Statt wie hier nur zwei Sende- und Empfangskanäle für die Basisstation und die Teilnehmerstation vorzusehen, können auch mehrere Sende- und Empfangskanäle vorhanden sein.

Der Modulator MOD11 in der Basisstation sendet auf der Trägerfrequenz BSTx1 und der Demodulator DMOD11 empfängt auf der Trägerfrequenz BSRx1. Nun soll in Senderichtung auf einen neuen Frequenzkanal mit der Trägerfrequenz BSTx2 und in Empfangsrichtung auf einen neuen Frequenzkanal mit der Trägerfrequenz BSRx2 umgeschaltet werden. Der Demodulator DMOD11' in der Teilnehmerstation ist derzeit auf den Empfangsträger TMRx1 eingestellt, um Signale des Modems MOD11 der Basisstation mit dem Sendeträger BSTx1 zu empfangen. In entgegengesetzter Richtung sendet der Modulator MOD11' der Teilnehmerstation mit dem Sendeträger TMTx1, der vom Demodulator DMOD11 der Basisstationen mit dem Empfangsträger BSRx1 empfangen wird. Nach der Umschaltung auf einen neuen Frequenzkanal sollte der Demodulator DMOD12' der Teilnehmerstation mit dem Empfangsträger TMRx2 die vom Modulator MOD12 mit dem Träger BSTx2 ausgesendeten Signale empfangen. Nach dem Umschalten sollte der Modulator MOD12' der Teilnehmerstationen seine Signale auf einem Sendeträger TMTx2 aussenden, welcher mit der Empfangsträgerfrequenz BSRx2 des Demoudlators DMOD12 in der Basisstation übereinstimmt. Es gilt nun, den neuen Empfangsträger TMRx2 und den neuen Sendeträger TMTx2 der Teilnehmerstation so einzustellen, daß sie eine möglichst geringe Ablage von dem neuen Sendeträger BSTx2 und dem neuen Empfangsträger BSRx2 der Basisstation aufweisen. Für die Ermittlung des neuen Empfangsträgers TMRx2 und des neuen Sendeträgers TMTx2 der Feststation ist ein Rechenwerk RW vorgesehen, das zweckmäßigerweise in der Basisstation angeordnet ist. Die Aufgabe des Rechenwerks RW kann aber auch teilweise von Schaltungen in der Basisstation und von Schaltungen in den Teilnehmerstationen übernommen werden.

Wie der Figur 3 zu entnehmen ist, werden dem Rechenwerk RW von der Basisstation der bisherige Sendeträger BSTx1, der bisherige Empfangsträger BSRx1, der neue Sendeträger BSTx2 und der neue Empfangsträger BSRx2 zugeführt. Außerdem erhält das Rechenwerk RW den bisherigen Empfangsträger TMRx1 und den bisherigen Sendeträger TMTx1 der Teilnehmerstation. Aus der Ablage zwischen den bisherigen Trägern der Basisstation und den bisherigen Trägern der Teilnehmerstation und den neuen Trägern der Basisstation werden in dem Rechenwerk RW die neuen Träger für den Teilnehmer berechnet.

Für den einzustellenden Sendeträger TMTx1 gilt:

$$TMTx1 = \frac{1}{C}\,[BSRx1 + n \cdot ZFLOBS + RFLOBS - RFLOTM - m' \cdot ZFLOTM]$$

mit

$$C = \frac{ZFLOTM}{ZFLOBS}$$

, der Drift zwischen den Referenzfrequenzen der Lokaloszillatoren ZFLOTM und ZFLOBS.

Ebenso kann ein Verhältnis zwischen den Referenzfrequenzen der Lokaloszillatoren RFLOBS und RFLOTM der Basisstation und der Teilnehmerstation gebildet werden:

$$R = \frac{RFLOTM}{RFLOBS}$$

Damit ergibt sich:

$$TMTx1 = \frac{1}{C}\,[BSRx1 + ZFLOBS(m' - n \cdot C) + RFLOBS(1 - R)]$$

Für die einzustellende Empfangsfrequenz TMRx1 gilt entsprechend:

$$TMRx1 = \frac{1}{C}\,[BSTx1 + m \cdot ZFLOBS + RFLOBS - RFLOTM - n' \cdot ZFLOTM]$$

Unter Einbeziehung des oben definierten Verhältnisses R gilt für die Empfangsfrequenz TMRx1:

$$TMRx1 = \frac{1}{C} [BSTx1 + ZFLOBS(m - n'\cdot C) + RFLOBS(1- R)]$$

Nachdem die Trägerfrequenzen BSTx1, BSRx1, TMTx1, TMRx1 in ihren nominellen Werten bekannt sind, wie auch die Vervielfachungsfaktoren m, n, m', n', sowie die nominellen Lokaloszillatorfrequenzen RFLOBS, ZFLOBS der Basisstation, können aus den oben aufgeführten Gleichungen die Faktoren C und R im Rechenwerk RW ermittelt werden:

$$C,R = f(BSTx1, BSRx1, TMTx1, TMRx1, m, n, m', n', ZFLOBS,$$

$$RFLOBS)$$

In gleicher Weise lassen sich Im Rechenwerk RW die gewünschten Sollwerte für die neuen Sende- und Empfangsträger TMTx2 und TMRx2 aus den vorgegebenen Trägerfrequenzen BSTx2 und BSRx2 der Basisstation errechnen:

$$TMTx2 = \frac{1}{C} [BSRx2 + ZFLOBS(m'-n\cdot C) + RFLOBS(1- R)]$$

$$TMRx2 = \frac{1}{C} [BSTx2 + ZFLOBS(m - n'\cdot C) + RFLOBS(1-R)]$$

Die Lokaloszillatorfrequenzen ZFLOBS und RFLOBS sind bekannt und bleiben unverändert, ebenso die Vervielfachungsfaktoren m, n, m', n'. Die Verhältnisse C und R wurden zuvor aus den Trägerfrequenzen TMTx1 und TMRx1 berechnet. Damit sind die beiden Gleichungen für die Trägerfrequenzen TMTx2 und TMRx2 lösbar.

Die beiden Sende- und Empfangskanäle in der Basisstation und in der Teilnehmerstation sind in der Figur 3 symbolisch als zwei Modulator- und zwei Demodulatorblöcke dargestellt. Die beiden Sende- und Empfangskanäle können zwar hardwaremäßig getrennt ausgeführt werden. Es ist aber auch möglich, einen Sendesignalpfad und einen Empfangssignal vorzusehen, der im Multiplexbetrieb vom bisherigen Frequenzkanal auf den neuen Frequenzkanal umschaltbar ist.

**Patentansprüche**

1. Verfahren zum Einstellen der Sendeträgerfrequenz in einer Teilnehmerstation eines Punkt-zu-Mehrpunkt Funkübertragungssystems, wobei eine Basisstation mit so vielen Modems (MOD1, DMOD1, ..., MODn, DMODn) ausgestattet ist, wie maximal Teilnehmerstationen mit ihr eine Funkverbindung aufnehmen können und ebenfalls jede Teilnehmerstation ein Modem (MOD1', DMOD1') besitzt, **dadurch gekennzeichnet,**

   - **daß** alle Empfangs- und alle Sendeträgerfrequenzen der Modems der Basisstation von einer gemeinsamen Referenzfrequenz (ZFLOBS) abgeleitet werden,
   - **daß** jeweils ein von einer Teilnehmerstation ausgesendeter Sendeträger mit der korrespondierenden Empfangsträgerfrequenz in der Basisstation verglichen wird,
   - **daß** eine ermittelte Frequenzablage zwischen dem Sendeträger der Teilnehmerstation und dem Empfangsträger der Basisstation der Teilnehmerstation mitgeteilt wird
   - und **daß** die Sendeträgerfrequenz der Teilnehmerstation so eingestellt wird, daß die Frequenzablage minimal wird.

2. Verfahren nach Anspruch 1, **dadurch gekennzeichnet, daß** auch die Empfangsträgerfrequenz der Teilnehmerstationen in Abhängigkeit von der Frequenzablage so verändert wird, daß die Frequenzablage minimal wird.

3. Verfahren nach Anspruch 1, **dadurch gekennzeichnet, daß** jedes Modem (MOD1, DMOD1; MOD1', DMOD1') in der Basisstation und in den Teilnehmerstationen mindestens zwei Empfangs- und zwei Sendekanäle aufweist, wobei von einem Empfangs-/Sendekanal auf einen anderen Empfangs-/Sendekanal umgeschaltet wird, wenn mit einem anderen Paar von Sende- und Empfangsträgerfrequenzen (BSTx1, BSRx1, TMRx1, TMTx1) Daten übertragen werden sollen, und daß vor dem Umschalten der Empfangs- und Sendekanäle das neue Paar von Sende- und Empfangsträgerfrequenzen (BSTx2, BSRx2, TMRx2, TMTx2) für die betroffene Teilnehmerstation aus der Frequenzablage zwischen dem vorherigen Sendeträger (TMTx1) der Teilnehmerstation und dem vorherigen Empfangsträger (BSRx1) der Basisstation und aus dem neuen Sendeträger (BSTx2) und dem neuen Empfangsträger (BSRx2) der Basisstation abgeleitet wird.

## Claims

1. Method for adjusting the transmission carrier frequency in a subscriber station of a point-to-multi-point radio transmission system, whereby a base station is equipped with as many modems (MOD1, DMOD1...., MODn, DMODn) as the maximum number of subscriber stations can make a radio link with and likewise each subscriber station possesses a modem (MOD1', DMOD1'), **characterized in that**

   - all receiving and all transmission carrier frequencies of the modems of the base station are derived from a common reference frequency (ZFLOBS).
   - in each case a transmission carrier sent by a subscriber station is compared with the corresponding receiving carrier frequency in the base station,
   - a frequency error detected between the transmission carrier of the subscriber station and the receiving carrier of the base station is communicated to the subscriber station,
   - and the transmission carrier frequency of the subscriber station is adjusted in such a way that the frequency error is minimal.

2. Method according to claim 1, **characterized in that** the receiving carrier frequency of the subscriber stations is also changed as a function of the frequency error in such a way that the frequency error is minimal.

3. Method according to claim 1, **characterized in that** each modem (MOD1, DMOD1; MOD1', DMOD1') in the base station and in the subscriber stations has at least two receiving and two transmission channels, whereby communication is switched over from a receiving/transmission channel to another receiving/transmission channel if data is to be transmitted with another pair of transmission and receiving carrier frequencies (BSTx1, BSRx1, TMRx1, TMTx1) and **in that** before the switch-over of the receiving and transmission channels the new pair of transmission and receiving carrier frequencies (BSTx2, BSRx2, TMRx2, TMTx2) for the subscriber station concerned is derived from the frequency error between the previous transmission carrier (TMTxl) of the subscriber station and the previous receiving carrier (BSRx1) of the base station and from the new transmission carrier (BSTx2) and the new receiving carrier (BSRx2) of the base station.

## Revendications

1. Procédé pour régler la fréquence porteuse d'émission dans un poste de réseau d'un système de radiotransmission d'un point à plusieurs points, dans lequel un poste de base est équipe d'autant de modems (MOD1, DMOD1, ..., MODn, DMODn) que les postes de réseau peuvent accepter avec leur liaison radio et chaque poste de réseau comporte également un modem (MOD1', DMOD1'), **caractérisé en ce**

   - **que** toutes les fréquences porteuses de réception et toutes les fréquences porteuses d'émission du modem du poste de base sont issues d'une fréquence de référence commune (ZFLOBS),
   - **qu'**une fréquence porteuse d'émission émise par un poste de réseau est comparée à la fréquence porteuse de réception correspondante du poste de base,
   - **qu'**une dérive de fréquence nominale déterminée est communiquée entre la fréquence porteuse d'émission du poste de réseau et la fréquence porteuse de réception du poste de base du poste de réseau,
   - et **que** la fréquence porteuse d'émission du poste de réseau est réglée de sorte que la dérive de fréquence nominale est minimale.

2. Procédé selon la revendication 1, **caractérisé en ce que** la fréquence porteuse de réception des postes de réseau aussi est modifiée en fonction de la dérive de fréquence nominale, de sorte que la dérive de fréquence nominale est minimale.

3. Procédé selon la revendication 1, **caractérisé en ce que** chaque modem (MOD1, DMOD1 ; MOD1', DMOD1') du poste de base et des postes de réseau présente au moins deux canaux d'émission et deux canaux de réception, moyennant quoi il est possible de passer d'un canal de réception/d'émission à un autre canal de réception/d'émission lorsque des données doivent être transmises avec une autre paire de fréquences porteuses d'émission et de réception (BSTx1, BSRx1, TMRx1, TMTx1), et **en ce que**, avant la commutation des canaux de réception et d'émission, la nouvelle paire de fréquences porteuses d'émission et de réception (BSTx2, BSRx2, TMRx2, TMTx2) pour le poste de réseau concerné est issue de la dérive de fréquence nominale entre la fréquence porteuse d'émission précédente (TMTx1) du poste de réseau et la fréquence porteuse de réception précédente (BSRx1) du poste de base et de la nouvelle fréquence porteuse d'émission (BSTx2) et de la nouvelle fréquence porteuse de réception (BSRx2) du poste de base.

## Fig. 1

## Fig. 2

# Fig. 3